# FASCICULE DE BREVET EUROPEEN

(11) **EP 2 921 770 B1**
(45) Date de publication et mention de la délivrance du brevet: **09.09.2020**
(21) Numéro de dépôt: 15159028.8
(22) Date de dépôt: 13.03.2015
(51) Int. Cl.: F21V 19/00, F21S 41/148, F21S 41/19, H01L 23/40

(54) **Ensemble d' éclairage et/ou de signalisation, comportant un adaptateur apte à être logé dans un module lumineux de véhicule automobile**
Beleuchtungs- und/oder Signalisierungseinheit, die einen Adapter umfasst, der an einem Beleuchtungsmodul eines Kraftfahrzeugs angebracht werden kann
Lighting and/or signalling unit comprising an adapter suitable for being housed in a light module of a motor vehicle

(30) Priorité: 20.03.2014 FR 1452339
(43) Date de publication de la demande: 23.09.2015
(73) Titulaire: VALEO ILUMINACION, 23600 Martos (ES)
(72) Inventeur: Aguilar del Moral, José-Antonio, 23009 Jaén (ES); Castillo Jimenez, José, 23600 Martos (ES); Rodriguez-Fuentes, Alberto, 23004 Jaén (ES); Rubia Mena, Juan-Antonio, 23600 Martos (ES); Ojeda, Francisco, 23600 Martos (ES)

(56) Documents cités:
- WO-A1-2012/048351
- WO-A1-2013/053626
- WO-A1-2014/028955
- DE-A1- 10 343 470
- DE-U1- 29 724 765
- JP-A- 2011 129 308

## Description

La présente invention a trait au domaine de l'éclairage et/ou de la signalisation d'un véhicule automobile et elle concerne plus particulièrement la conception de modules lumineux comportant une source lumineuse orientée pour émettre des rayons en direction d'un collecteur.

On connaît de tels modules, dans lesquels la source lumineuse consiste en une diode électroluminescente, que l'on cherche à positionner au foyer d'un collecteur sensiblement elliptique pour que les rayons émis soient dirigés parallèlement à l'axe optique vers un système optique en sortie du module.

On comprend que la conformité de l'orientation des rayons sortants dépend notamment du bon positionnement de la diode électroluminescente émettrice des rayons par rapport au collecteur et notamment par rapport au premier des deux foyers du collecteur, le système optique étant placé au voisinage du deuxième foyer. Les constructeurs automobiles visent à obtenir dans leur procédé de fabrication et de montage des modules une grande précision à cet effet.

Les diodes électroluminescentes présentent entre autres avantages, une durée de vie supérieure à celle que peuvent présenter d'autres types de sources lumineuses. Toutefois, on comprend que pour des raisons diverses, le propriétaire du véhicule puisse avoir besoin de remplacer la diode électroluminescente dans le module. Une nouvelle fois, le positionnement de cette nouvelle source lumineuse doit être très précis, pour que la qualité de l'éclairage et/ou de la signalisation du véhicule reste la même. Ce problème se pose également, et à plus grande fréquence, lorsque les sources lumineuses sont formées par exemple par des lampes à décharge ou des lampes allogènes.

Le document WO 2014/028955 A1 décrit un module lumineux comprenant une source montée sur un support, le support permettant d'assurer un positionnement précis d'un réflecteur par rapport à la source. Le réflecteur possède des moyens de rappel élastique.

Le document FR2950129 divulgue un module optique comportant un moyen support d'un collecteur. Le moyen support comporte un logement apte à recevoir un adaptateur sur lequel sont fixés une plaque de circuits imprimés et une diode électroluminescente. Lorsque la diode nécessite d'être changée, il suffit alors de retirer l'adaptateur, de placer une nouvelle diode sur la plaque de circuits imprimés et de replacer l'adaptateur dans le logement.

L'adaptateur est maintenu en place dans deux directions de l'espace par les parois du logement et on prévoit des moyens de blocage en position dans la troisième direction de l'espace pour figer la position de l'adaptateur, qui doit être précise pour que la diode portée par l'adaptateur soit positionnée précisément par rapport au premier foyer du collecteur, qui collecte les rayons émis depuis la diode.

Un problème de la présente invention est de perfectionner ce type de module lumineux pour permettre d'assurer la position correcte de la source lumineuse par rapport au collecteur, et ce quel que soit le nombre de remplacements de la source lumineuse effectués.

Si l'invention concerne un module lumineux tel qu'il va être décrit ci-après en ce qu'il comporte des moyens de positionnement d'un adaptateur porteur d'une source lumineuse à placer au foyer d'un système optique, l'invention concerne également l'adaptateur correspondant.

L'adaptateur selon l'invention, apte à être placé et maintenu en position dans un logement d'un moyen support d'un collecteur optique d'un véhicule automobile, comporte une source lumineuse rendue solidaire d'une face de l'adaptateur, et il comporte, sur une face opposée à la face de support de cette source lumineuse au moins une zone de réception de moyens de plaquage selon une première direction, ainsi que des moyens de rappel élastique aptes à être compressés selon une deuxième direction distincte de ladite première direction, notamment perpendiculaire à la première direction.

Selon différentes caractéristiques, prises seules ou en combinaison, on prévoira que :
- les moyens de rappel élastique sont sur une tranche de l'adaptateur, la tranche étant notamment perpendiculaire à ladite face de support ;
- les moyens de rappel élastique présentent la forme d'un ressort à lame ;
- le ressort à lame est fixé en son centre pour être plaqué contre la tranche de l'adaptateur, et présentant une forme courbe de sorte que dans une position de repos dudit ressort, ses extrémités s'éloignent de ladite tranche ;

- le ressort à lame comporte en outre une patte qui s'étend à partir du centre de celle-ci et qui vient en prise avec un pion solidaire de la face de l'adaptateur opposée à la face de support de ladite source lumineuse ;
- la source lumineuse est une diode électroluminescente ; selon une réalisation elle est portée par une plaque de circuits imprimés rendue solidaire de ladite face de support de l'adaptateur ;
- la face opposée à la face de support de ladite source lumineuse comporte des nervures qui s'étendent en saillie dans la première direction ;
- la zone de réception de moyens de plaquage consiste en des rainures qui s'étendent selon la deuxième direction le long des extrémités de l'adaptateur ;
- la zone de réception de moyens de plaquage consiste en un canal transversal qui s'étend perpendiculairement à la deuxième direction.

L'invention concerne également un module lumineux, notamment d'éclairage et/ou de signalisation d'un véhicule automobile, tel que défini par la revendication 10 et comportant un collecteur apte à réfléchir des rayons lumineux pour que ceux-ci émettent selon un axe optique donné, et comportant un moyen support recouvrant en partie ledit collecteur, ledit moyen support présentant un logement apte à recevoir un adaptateur tel que décrit précédemment. Avantageusement, le module selon l'invention comporte des moyens distincts pour le plaquage de l'adaptateur selon une première direction d'une part et pour l'ajustement en position de l'adaptateur selon une deuxième direction distincte de ladite première direction d'autre part, notamment perpendiculaire à ladite première direction.

Selon une réalisation de l'invention, le module lumineux comprend des moyens de rappel élastique aptes à être compressés selon ladite deuxième direction. Ces moyens de rappel élastique sont notamment portés par le moyen support et sont destinés à être compressés par un adaptateur, pouvant alors quant à lui être dépourvu de moyens de rappel élastique. Ces moyens de rappel élastique portés par le module lumineux peuvent présenter les mêmes caractéristiques que celles des moyens de rappel élastique décrits ci-dessus pour l'adaptateur.

On pourra prévoir que les moyens d'ajustement en position portés par le module consistent en une vis de serrage disposé transversalement à une paroi d'extrémité du logement, ladite vis étant adaptée à coopérer avec un alésage taraudé réalisé dans ladite face d'extrémité pour pénétrer dans le logement selon ladite deuxième direction sous l'effet de sa rotation, afin de s'appuyer contre l'adaptateur. Afin d'affiner l'ajustement selon cette deuxième direction, la vis de serrage pourra être une vis micrométrique.

Selon des caractéristiques de deux modes de réalisation distincts, la paroi d'extrémité du logement porteuse de l'alésage taraudé pourra être formée dans l'épaisseur du moyen support, ou bien par une pièce rapportée et fixée sur le moyen support.

Les moyens de plaquage présentent avantageusement la forme d'un fil rigide articulé, à titre d'exemple sur le moyen support, de manière à passer d'une position ouverte, dans laquelle le fil laisse libre accès au logement formé dans le moyen support, à une position fermée, dans laquelle le fil est en travers dudit logement, ledit fil étant maintenu dans cette position fermée par encliquetage de crochets formés par déformation du fil dans des moyens de réception femelles prévus à cet effet sur le moyen support.

Selon une réalisation de l'invention, les moyens de plaquage présentent la forme d'un ressort plat fixé sur des pions formés latéralement dans le moyen support du module, de manière à s'étendre transversalement au-dessus de l'adaptateur.

L'invention concerne en outre un ensemble d'éclairage et ou de signalisation d'un véhicule automobile, comportant un module lumineux et un adaptateur, dans lequel :
- l'adaptateur est placé et maintenu en position dans ledit logement dudit moyen support du collecteur optique, comporte une source lumineuse rendue solidaire d'une face de l'adaptateur, et comporte sur une face opposée à la face de support de ladite source lumineuse au moins une zone de réception de moyens de plaquage selon une première direction,
- le module et l'adaptateur portent des moyens distincts d'une part pour le plaquage de l'adaptateur contre le moyen support du module selon une première direction et d'autre part pour l'ajustement en position, selon une deuxième direction distincte de ladite première direction, de l'adaptateur dans un logement formé dans ledit moyen support, et
- l'ensemble d'éclairage et ou de signalisation comporte des moyens de rappel élastique aptes à être compressés selon ladite deuxième direction, ces moyens de rappel élastiques étant positionnés entre le support et le l'adaptateur et portés par le support et/ou l'adaptateur.

La deuxième direction peut par exemple être perpendiculaire à ladite première direction

Dans un tel ensemble, on pourra prévoir que les moyens d'ajustement en position comportent une vis de réglage portée par le moyen support ainsi qu'un moyen de rappel élastique porté par l'adaptateur, l'action de la vis de réglage contre une face de l'adaptateur entraînant la compression des moyens de rappel élastique entre une face opposée de l'adaptateur contre une paroi du logement formé dans le moyen support.

Selon une réalisation, l'adaptateur est un adaptateur selon l'invention, tel que décrit précédemment.

L'invention concerne également un véhicule automobile dans lequel un module lumineux tel qu'il a été décrit précédemment est mis en place pour l'éclairage et/ou la signalisation du véhicule automobile.

D'autres caractéristiques et avantages de l'invention apparaîtront à la lecture de la description détaillée d'un mode de réalisation qui va suivre et pour la compréhension de laquelle on se reportera aux figures annexées parmi lesquelles :

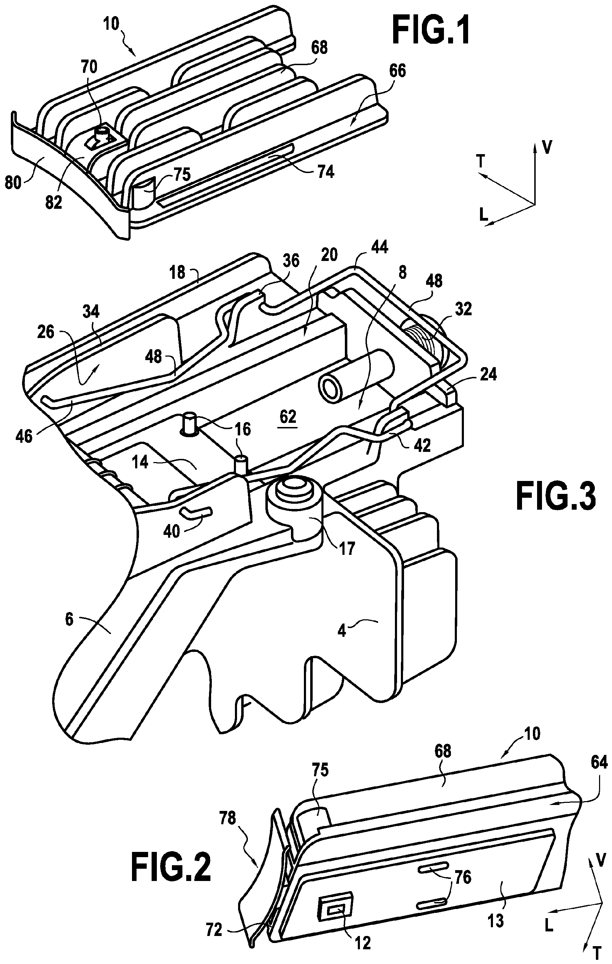

- les figures 1 et 2 sont des représentations en perspectives, respectivement de trois quart dessus et de trois quart dessous, de l'adaptateur selon l'invention ;
- la figure 3 est une représentation en perspective, de trois quart dessus, du moyen support et du collecteur associé, sans l'adaptateur illustré sur les figures 1 et 2, rendant visible le logement apte à le recevoir, la figure représentant également les moyens de plaquage associés représentés dans une position fermée et les moyens de serrage associés ;
- la figure 4 est une vue partielle de côté du module lumineux, l'adaptateur étant en position dans le logement du moyen support, et les moyens de plaquage associés étant représentés en cours de fermeture ;
- la figure 5 est une vue partielle de dessus du module lumineux, illustré sur la figure 4 ; et
- les figures 6 et 7 sont des vues partielles respectivement de trois quart avant et de trois quart arrière d'un deuxième mode de réalisation d'un module lumineux selon l'invention.

Dans ce qui suit, on désignera par direction longitudinale L la direction dans le sens de circulation du véhicule automobile, et par direction transversale T une direction horizontale et perpendiculaire à cette direction longitudinale. La direction verticale V désignera la direction perpendiculaire aux deux précédentes, qui définissent par ailleurs un plan horizontal. Le trièdre L,V,T est placé sur les figures pour faciliter la lecture. Mais on comprendra que le module lumineux peut être agencé selon une autre orientation sans sortir du contexte de l'invention.

Tel qu'illustré sur les figures, un ensemble d'éclairage et/ou de signalisation comporte un module lumineux 2 formé d'un moyen support 4 sur lequel est rapporté un collecteur sensiblement elliptique 6 apte à dévier les rayons lumineux émis par une source lumineuse. Le support présente un logement 8 pour recevoir un adaptateur 10 porteur de la source lumineuse.

Dans l'exemple qui va suivre, la source lumineuse est une diode électroluminescente 12, rapportée sur une plaque de circuits imprimés 13 et apte à émettre des rayons lumineux en fonction d'une instruction de commande électrique. On comprendra que d'autres types de sources lumineuses pourraient être utilisés sans sortir du contexte de l'invention.

Le module lumineux comporte en outre un élément optique, ici non représenté, associé au collecteur et porté également par le moyen support, cet élément optique étant disposé au deuxième foyer du collecteur tandis que la source lumineuse doit être disposée sensiblement au premier foyer du collecteur. Cet agencement permet à la majorité des rayons émis par la source lumineuse et passant par le second foyer du collecteur d'être réfléchis par l'élément optique selon la direction d'éclairage correspondant à son axe optique.

Le collecteur 6 comporte une surface réfléchissante sensiblement elliptique, qui peut être réalisée sous la forme d'un secteur angulaire de pièce sensiblement de révolution. On peut cependant noter que la surface peut ne pas être parfaitement elliptique et avoir plusieurs profils spécifiques prévus pour optimiser la répartition lumineuse dans le faisceau d'éclairage produit par le module, tel que cela est illustré sur les figures.

Le collecteur comporte en outre une platine de fixation 14, qui prolonge transversalement une extrémité du collecteur, de manière à offrir une surface d'appui sensiblement plane apte à venir en contact avec une face inférieure du moyen support. La platine de fixation comporte en outre des pions d'indexage 16 qui s'étendent en saillie de la platine, et qui, tel que cela sera décrit ci-après, sont dégagés lorsque le collecteur est rapporté contre le moyen support au niveau du logement 8.

Le moyen support 4 permet ainsi la fixation du collecteur, notamment par l'intermédiaire de moyens de vissage et d'un cylindre de fixation 17, et il permet en outre la fixation de la source lumineuse au voisinage du premier foyer du collecteur, via l'adaptateur.

La face supérieure du moyen support, tournée à l'opposé du collecteur, comporte des nervures 18 qui s'étendent en saillie du support. On comprendra à la description qui va suivre que ces nervures jouent avantageusement le rôle de dissipateurs thermiques, de manière à évacuer la chaleur générée par la plaque de circuits imprimés lorsque la source lumineuse est formée par une diode électroluminescente.

Le moyen support 4 comporte en outre le logement 8 de réception de l'adaptateur 10 tel qu'il va être décrit dans un mode de réalisation complémentaire ci-après.

Le logement 8 est formé par une zone du moyen support dépourvue de nervures et il comporte une paroi de fond 20 et quatre parois montantes.

Dans la description qui va suivre, le logement 8 est orienté de sorte que la paroi de fond s'étend sensiblement horizontalement et de sorte que les parois montantes s'étendent sensiblement verticalement. Par ailleurs, on distingue parmi les parois montantes deux parois avant 22 et arrière 24 qui s'étendent transversalement et deux parois longitudinales 26 et 28. Les parois transversales avant et arrière sont ainsi identifiées en fonction de leur position sur l'axe longitudinal, la paroi transversale avant 22 étant la paroi la plus proche de la face de sortie du module lumineux. On comprend que les orientations ici choisies pourraient être modifiées sans sortir du contexte de l'invention dès lors que l'agencement général du module est conforme à ce que qui va être décrit avec une première direction qui correspond ici à la direction verticale, une deuxième direction qui correspond ici à la direction longitudinale, et une troisième direction qui correspond ici à la direction transversale.

La paroi transversale avant 22 forme une surface de contact plane verticale.

La paroi transversale arrière 24 s'étend parallèlement à la paroi transversale avant, et elle est avantageusement formée par une pièce rapportée, tel qu'illustré sur les figures, bien qu'elle puisse être directement formée dans la matière du moyen support, de la même manière que la paroi transversale avant. On comprendra que le fait d'avoir une pièce rapportée facilite l'insertion et le retrait de l'adaptateur dans le logement, en nécessitant toutefois une opération de retrait préalable éventuel de la pièce rapportée. La paroi transversale arrière est en outre percée en son centre et usinée pour former un alésage taraudé 30 apte à coopérer avec une vis de serrage 32.

La vis de serrage 32 présente à cet effet un diamètre et un pas de filetage externe correspondant sensiblement au diamètre interne de l'alésage taraudé. La vis de serrage se déplace selon la deuxième direction, ici longitudinalement, par rapport à la paroi transversale arrière 24 lorsque la vis est mise en rotation. Elle se déplace entre une position de dégagement, dans laquelle elle est peu ou pas en saillie dans le logement, et une position de serrage, dans laquelle elle s'étend en saillie de la paroi transversale arrière à l'intérieur du logement. On pourra prévoir d'utiliser une vis micrométrique pour affiner le réglage du déplacement longitudinal de la vis.

Les parois longitudinales 26 et 28 sont formées successivement dans la direction longitudinale par une première nervure 34 disposée en saillie de la face supérieure du moyen support et par une deuxième nervure 36 formant plot et séparée de la première nervure par un dégagement latéral 38. Elles comportent un trou 40 traversant la première nervure, et des moyens femelles d'encliquetage formés par une gorge 42 réalisée transversalement sur une face arrière de la deuxième nervure, de sorte que la gorge est tournée à l'opposé de la première nervure. Tel que cela sera décrit ci-après, les trous permettent l'articulation de moyens de plaquage, qui sont aptes, tel que cela sera décrit en détail ci-après, à être appliqués sur l'adaptateur lorsqu'il est en place dans le logement, en appui contre la paroi de fond, et les dégagements permettent le passage des moyens de plaquage autour de la deuxième nervure pour que ces moyens de plaquage puissent s'encliqueter et se figer dans une position fermée.

Ainsi, on prévoit un fil 44 formant les moyens de plaquage, articulé sur le moyen support au niveau des deux trous pour pouvoir être actionné entre une position ouverte dans lequel il permet le retrait et l'insertion de l'adaptateur et une position fermée dans laquelle il est plaqué contre l'adaptateur en le bloquant dans la première direction, ici verticalement.

Le fil articulé 44 présente une forme de U, avec deux branches latérales 46 qui sont sensiblement les mêmes à l'exception de leur extrémité libre, et une branche transversale 48 reliant ces deux branches latérales.

Chaque branche latérale 46 comporte successivement dans le prolongement de la branche transversale une portion de raccordement 50 sensiblement perpendiculaire à la branche transversale, une portion d'écartement transversal 52 formant un crochet qui comporte au moins une portion d'accroché 54 sensiblement parallèle à la branche transversale, une portion d'appui 56 sensiblement perpendiculaire à la branche transversale qui présente une déformation formant un coude 58 selon une direction perpendiculaire à la portion de raccordement et à la branche transversale, et une extrémité libre 60 prolongeant perpendiculairement la portion d'appui.

Une des branches présente une extrémité libre plus recourbée que l'autre, de manière à ce que lorsque ces extrémités sont engagées dans les trous correspondants formés dans les parois longitudinales du logement, pour former des points d'ancrage du fil dans le moyen support, l'une de ces extrémités empêche l'échappement transversal du fil.

La paroi de fond 20 du logement est trouée en son centre, et le trou correspondant 62 présente des dimensions équivalentes à celles de la plaque de circuits imprimés 13.

La paroi de fond sert de surface d'appui à l'adaptateur 10 selon une première direction, ici verticale, tandis que le trou sert de dégagement principalement pour laisser passage à la plaque de circuits imprimés 13 et aux rayons lumineux émis par la diode électroluminescente portée par cette plaque de circuits imprimés.

La paroi de fond, notamment sur les branches longitudinales qui bordent transversalement le trou, est avantageusement recouverte d'une couche de matière conductrice thermique.

Tel qu'il vient d'être décrit, le logement 8 est apte à recevoir l'adaptateur 10 porteur de la source lumineuse pour que celle-ci soit placée correctement au premier foyer du collecteur.

L'adaptateur 10 présente une forme de parallélépipède, qui comporte deux faces planes parallèles, avec une première face 64 plane tournée vers l'intérieur du module lorsque l'adaptateur est en place dans le module, et une deuxième face 66 plane opposée, et quatre cotés parallèles deux à deux parmi lesquels deux côtés transversaux qui s'étendent aux extrémités longitudinales de l'adaptateur.

La première face 64 porte la source lumineuse, par l'intermédiaire de la plaque de circuits imprimés 13 sur laquelle est fixée la diode électroluminescente apte à émettre la majorité de son énergie lumineuse à l'opposé de l'adaptateur, vers la surface réfléchissante de la surface sensiblement elliptique du collecteur.

La deuxième face 66 porte des nervures 68 formant dissipateurs thermiques, qui s'étendent à cet effet en saillie verticale de l'adaptateur. On peut constater que lorsque l'adaptateur est en place dans le logement, on forme ainsi une zone continue de nervures formant dissipateurs thermiques, les nervures associées à l'adaptateur correspondant aux nervures amputées au moyen de support par la formation du logement.

La deuxième face porte également un pion 70 qui s'étend en saillie verticale à proximité d'un premier côté transversal 72, ledit pion s'étendant verticalement au-dessus du bord libre des nervures.

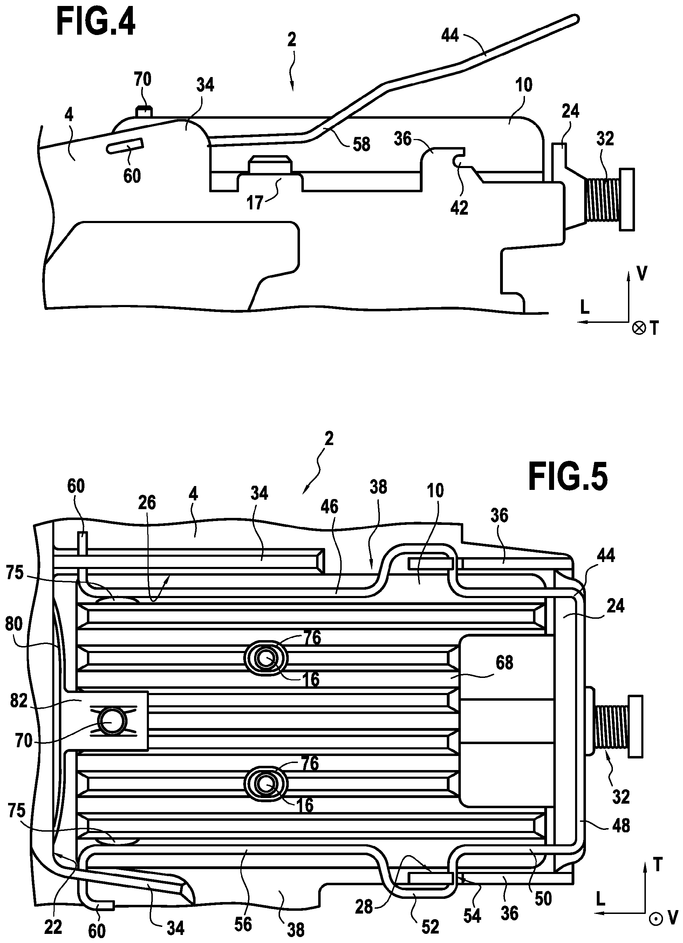

La deuxième face porte en outre deux rainures longitudinales 74 qui s'étendent le long des côtés longitudinaux, de manière à former des moyens de réception des moyens de plaquage lorsque ceux-ci sont en position fermée, tel que cela est visible sur la figure 5.

Un déflecteur 75 est disposé sur la deuxième face au voisinage de chaque rainure longitudinale, et forme une surépaisseur de la nervure 68 directement voisine de cette rainure.

Afin de permettre l'ajustement longitudinal de l'adaptateur dans le logement, l'adaptateur comporte deux trous traversants 76, de forme oblongue de grand axe longitudinal, dans lequel coopèrent les pions d'indexage 16 portés par le moyen support du collecteur.

Les deux côtés transversaux consistent en des parois planes, formant une surface d'appui régulière.

L'adaptateur 10 porte en outre des moyens élastiques de rappel 78 qui s'étendent sensiblement en regard du premier côté transversal 72. Ces moyens élastiques présentent ici la forme d'un ressort à lame courbe 80 disposée en regard du premier côté, et une patte 82 perpendiculaire à la lame et courbée pour venir en prise, par exemple par des moyens d'encliquetage appropriés, avec le pion 70 solidaire de l'adaptateur.

La lame courbe 80 est plaquée contre le premier côté transversal 72 en son centre, et elle s'écarte de l'adaptateur à ses extrémités. On comprend que le ressort est ainsi agencé pour travailler en compression, et pour fournir en réponse une contrainte longitudinale lorsque l'adaptateur est en place dans le logement.

Selon l'invention, le module comporte des moyens distincts pour le plaquage de l'adaptateur contre la paroi de fond de logement et son blocage dans une première direction d'une part et pour l'ajustement en position de l'adaptateur dans le logement selon une deuxième direction perpendiculaire à ladite première direction d'autre part.

Ces moyens distincts comportent d'une part des moyens d'accroché portés par le moyen support et un fil rigide articulé sur ces moyens d'accroché qui forment les moyens de plaquage, et d'autre part le ressort à lame courbe et la vis de serrage qui forment les moyens d'ajustement.

Lorsque l'adaptateur est en place dans le logement du support, et que d'une part le fil articulé est en position fermée, plaqué contre l'adaptateur et bloqué dans cette position par encliquetage sur le moyen support, et que d'autre part la vis de serrage est en position de serrage, comprimant axialement le ressort associé des moyens d'ajustement, l'adaptateur est maintenu dans le logement selon trois directions.

Le moyen support assure le lien mécanique entre l'adaptateur porteur de la diode électroluminescente et le collecteur, et on peut ainsi s'assurer par un respect des côtes de montage de la position correcte de la diode par rapport au premier foyer du collecteur.

On va maintenant décrire plus en détails la coopération de l'adaptateur et du moyen support dans le module lumineux selon l'invention, et notamment dans le cadre d'un remplacement d'une source lumineuse dans ce module.

On retire à cet effet l'adaptateur de sa position fonctionnelle dans le module, telle qu'elle est visible sur la figure 5. Dans un premier temps, on joue sur les moyens d'ajustement selon la deuxième direction en dévissant la vis de serrage. Celle-ci se déplace alors en translation selon cette deuxième direction, perpendiculairement à la paroi transversale arrière du logement, dans le sens d'un dégagement, ce qui provoque une détente du ressort à lame courbe jusque-là comprimé contre la paroi transversale avant du logement. Cette détente élastique force l'adaptateur à l'éloignement par rapport à la paroi transversale avant, l'adaptateur étant guidé longitudinalement par la présence des parois longitudinales qui borde le logement et par la coopération des pions d'indexage avec les lumières oblongues formées dans l'adaptateur et la plaque de circuits imprimés. On note que l'extrémité libre de la vis de serrage assure une butée du déplacement lors de la détente élastique du ressort. Dans un deuxième temps, on désengage fil articulé des gorges dans lesquelles il est encliqueté et on articule ce fil autour de l'axe passant par ses points d'ancrage dans le moyen support, pour passer d'une position fermée dans laquelle il bloque l'adaptateur dans une première direction, ici verticale, à une position ouverte dans laquelle l'adaptateur peut être dégagé verticalement.

On change alors la source lumineuse associée à l'adaptateur. Dans le cas d'une source lumineuse formée par une diode électroluminescente et une plaque de circuits imprimés associée, on peut retirer la diode de la plaque et laisser cette dernière en place contre la première face de l'adaptateur, ou bien retirer la plaque de circuits imprimés et en remettre une autre avec une diode neuve.

On place alors l'adaptateur dans le logement, en s'assurant auparavant que le fil articulé est dans sa position ouverte et que la vis de serrage est dans sa position de dégagement. L'adaptateur est amené contre la paroi de fond du logement, éventuellement en plaquant le ressort à lame contre la paroi transversale avant du logement.

Dans cette position, la plaque de circuits imprimés se positionne dans l'ouverture formée dans la paroi de fond, de sorte que d'une part, on laisse passage aux rayons vers le collecteur, et de sorte que d'autre part, la plaque n'est pas au contact du moyen support, ce qui permet d'éviter une surchauffe des circuits électriques. La plaque de circuits imprimés s'étend pour cela en regard de la platine de fixation du collecteur, et elle est traversée par les pions d'indexage portés par cette platine et qui sont logés dans les lumières formés dans l'adaptateur et la plaque de circuits imprimés.

On manipule le fil articulé pour l'amener dans la position fermée, dans laquelle il plaque l'adaptateur contre la paroi de fond. Les déflecteurs (tel que cela est visible sur la figure 5) permettent de régler la position transversale du fil, alors que les formes d'extrémité courbes du fil permettent un jeu dans cette direction transversale. Les crochets latéraux formés sur le fil sont encliquetés dans les gorges correspondantes formées dans les parois latérales du logement. On bloque ainsi la position selon une première direction, ici verticale, de l'adaptateur.

On procède ensuite au blocage en position de l'adaptateur selon une deuxième direction perpendiculaire, ici la direction longitudinale. A cet effet, on réalise le vissage de la vis de serrage dans l'alésage taraudé. L'extrémité de la vis avance à l'intérieur du logement et pousse l'adaptateur, par contact sur son deuxième côté transversal, qui se rapproche ainsi de la paroi transversale avant du logement.

La rotation de la vis entraîne son déplacement transversalement à la pièce rapportée formant la paroi transversale arrière du logement et portant la vis de serrage, c'est à dire dans la première direction, et ceci génère le déplacement de l'adaptateur dans cette même direction, l'adaptateur étant poussé par contact de l'extrémité de la vis sur le deuxième coté transversal de l'adaptateur. Ce dernier est ainsi poussé vers la paroi transversale avant du logement du support, et de la sorte, le ressort à lame est plaqué contre la paroi transversale avant. La forme oblongue des lumières, coopérant avec les pions d'indexage, permet un guidage longitudinal de ce déplacement. La coopération des pions d'indexage et des trous de forme oblongue assure la position transversale de l'adaptateur et permet simultanément l'ajustement longitudinal sous l'effet du ressort et de la vis de serrage.

Le revêtement thermique réalisé sur la paroi de fond, contre laquelle vient s'appuyer l'adaptateur, permet de s'assurer que l'ajustement longitudinal est fait sans réaction de frottement.

Alternativement à un revêtement thermique, les surfaces de contact entre la paroi de fond et l'adaptateur présentent une finition suffisamment précise pour assurer un contact entre l'adaptateur et la paroi de fond, avec le moins d'air possible entre les deux, de manière à assurer le transfert de chaleur entre l'adaptateur et la paroi de fond.

La description qui précède explique clairement comment l'invention permet d'atteindre les objectifs qu'elle s'est fixés et notamment de proposer un adaptateur et un moyen support, dans un module lumineux dans son ensemble, qui permettent de remplacer une source lumineuse en s'assurant au remontage que la position de la source neuve est aussi fiable que la position de la source initialement en place. Les moyens mis en place permettent des manipulations simples, tout en assurant une grande précision de montage. L'adaptateur et le moyen support portent tout ou partie de moyens qui combinés permettent le maintien en position de l'ensemble dans les trois directions de l'espace.

Avantageusement, la réalisation des moyens d'ajustement en position selon la deuxième direction perpendiculaire à la première direction selon laquelle l'adaptateur est plaqué contre la paroi de fond permet d'assurer une grande précision dans le réglage selon cette deuxième direction tout en proposant une réalisation facilitée. En effet, on observe que le ressort à lame force l'ajustement de la vis de serrage dans l'alésage taraudé, de sorte qu'une tolérance peut être observée dans la précision de réalisation des filetages et taraudages de ces moyens de vissage.

Bien entendu, diverses modifications peuvent être apportées par l'homme du métier aux structures du module lumineux, qui viennent d'être décrites à titre d'exemples non limitatifs.

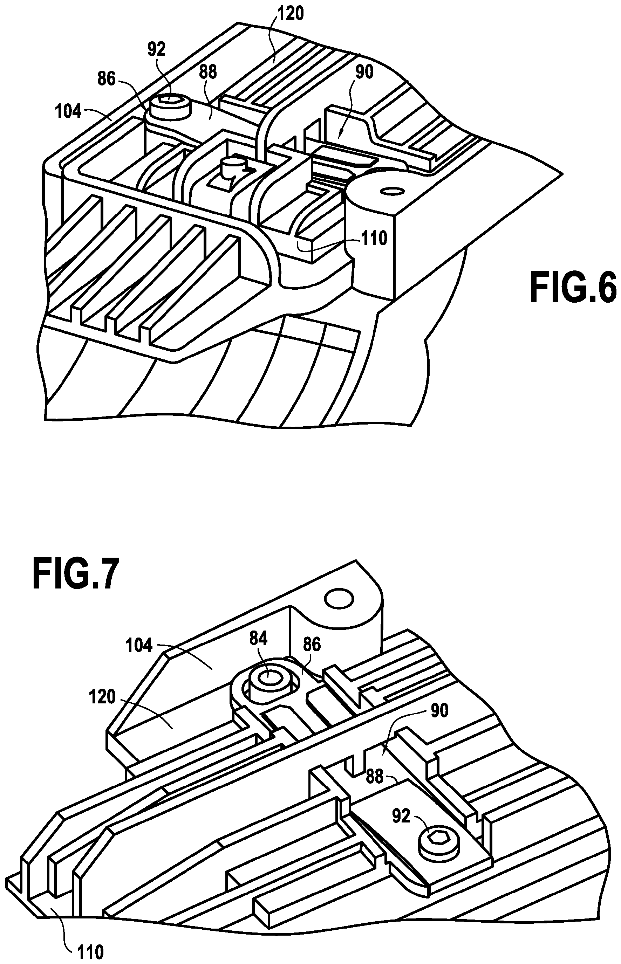

A titre d'exemple, on décrit un deuxième mode de réalisation illustré sur les figures 6 et 7, et particulier en ce que les moyens de plaquage ne présentent plus la forme d'un fil articulé, mais d'un ressort plat fixé sur le côté du logement et qui s'étend sur la face supérieure de l'adaptateur lorsque celui-ci est positionné dans le logement.

Le support 104 comporte sur la paroi de fond 120 deux pions latéraux 84 aptes à coopérer avec des œillets 86 disposés en saillie latérale de l'adaptateur 110. Les œillets présentent un alésage traversant de forme oblongue, dont le grand axe s'étend dans la deuxième direction de réglage, de manière à permettre le réglage de la position de l'adaptateur dans le logement tel qu'il a pu être décrit précédemment. Lors de la mise en place de l'adaptateur dans le logement, on vient positionner les pions latéraux dans les trous des œillets, puis on vient fixer un ressort plat 88 au niveau de ces pions, de sorte qu'il s'étend sensiblement en travers de l'adaptateur, au-dessus de celui-ci de manière à appliquer par les moyens de fixation du ressort sur les pions et par la forme du ressort un effort de plaquage de l'adaptateur contre le support. Tel qu'illustré, on peut prévoir d'aménager un canal transversal 90 pour recevoir le ressort. On comprend que le ressort peut être fixé au niveau des pions, et notamment de leur face supérieure libre, par différents moyens et notamment par vissage, en prévoyant une vis de fixation 92 apte à coopérer avec un alésage taraudé à l'intérieur des pions. On vient visser le ressort contre l'adaptateur lorsque celui-ci est en place et on dévisse le ressort pour le retirer lorsqu'on souhaite retirer l'adaptateur pour changer la source lumineuse. Si une opération de retrait du ressort plat par vissage peut paraître plus laborieuse qu'une opération d'escamotage par rotation du fil articulé, ce mode de réalisation peut s'avérer particulièrement intéressant dans les cas où l'encombrement est une problématique importante, et où il n'est notamment pas possible de faire pivoter le fil articulé d'une position ouverte permettant le passage de l'adaptateur à une position fermée. L'ajustement du positionnement peut se faire ensuite selon la deuxième direction tel que décrit précédemment.

## Revendications

1. Adaptateur (10 ; 110) apte à être placé et maintenu en position dans un logement (8) d'un moyen support (4 ; 104) d'un collecteur optique (6) d'un véhicule automobile, comportant une source lumineuse (12, 13) rendue solidaire d'une face de l'adaptateur, comportant sur une face (66) opposée à la face de support (64) de ladite source lumineuse au moins une zone de réception (74 ; 90) de moyens de plaquage selon une première direction, **caractérisé en ce que** l'adaptateur comporte des moyens de rappel élastique (78) aptes à être compressés selon une deuxième direction distincte de ladite première direction, notamment perpendiculaire à ladite première direction.

2. Adaptateur selon la revendication 1, **caractérisé en ce que** les moyens de rappel élastique (78) sont sur une tranche de l'adaptateur, la tranche étant notamment perpendiculaire à ladite face de support.

3. Adaptateur selon la revendication 2, **caractérisé en ce que** les moyens de rappel élastique (78) présentent la forme d'un ressort à lame (80).

4. Adaptateur selon la revendication 3, **caractérisé en ce que** le ressort à lame (80) est fixé en son centre pour être plaqué contre la tranche de l'adaptateur (10), et présentant une forme courbe de sorte que dans une position de repos dudit ressort, ses extrémités s'éloignent de ladite tranche.

5. Adaptateur selon la revendication 3 ou 4, **caractérisé en ce que** le ressort à lame (80) comporte en outre une patte (82) qui s'étend à partir du centre de celle-ci et qui vient en prise avec un pion (70) solidaire de la face (66) de l'adaptateur opposée à la face de support (64) de ladite source lumineuse.

6. Adaptateur selon l'une des revendications 1 à 5, **caractérisé en ce que** ladite source lumineuse est une diode électroluminescente (12) portée par une plaque de circuits imprimés (13) rendue solidaire de ladite face de support (64) de l'adaptateur.

7. Adaptateur selon l'une des revendications 1 à 6, **caractérisé en ce que** la face (66) opposée à la face de support (64) de ladite source lumineuse comporte des nervures (68) qui s'étendent en saillie dans la première direction.

8. Adaptateur selon l'une des revendications 1 à 7, **caractérisé en ce que** la zone de réception (74) de moyens de plaquage consiste en des rainures qui s'étendent selon la deuxième direction le long des extrémités de l'adaptateur.

9. Adaptateur selon l'une des revendications 1 à 7, **caractérisé en ce que** la zone de réception de moyens de plaquage consiste en un canal transversal (90) qui s'étend perpendiculairement à la deuxième direction.

10. Module lumineux (2), notamment d'éclairage et/ou de signalisation d'un véhicule automobile, comportant au moins un collecteur (6) apte à réfléchir des rayons lumineux pour que ceux-ci émettent selon un axe optique donné, un moyen support (4 ; 104) recouvrant en partie ledit collecteur, et un adaptateur (10 ; 110) portant une source lumineuse (12, 13) apte à émettre lesdits rayons lumineux, ledit moyen support présentant un logement (8) apte à recevoir ledit adaptateur, **caractérisé en ce que** ledit module comporte des moyens distincts pour le plaquage de l'adaptateur selon une première direction d'une part et pour l'ajustement en position de l'adaptateur selon une deuxième direction distincte de ladite première direction, notamment perpendiculaire à ladite première direction d'autre part.

11. Module lumineux selon la revendication 10, **caractérisé en ce qu'**il comprend des moyens de rappel élastique aptes à être compressés selon ladite deuxième direction.

12. Module lumineux selon la revendication 10 ou 11, **caractérisé en ce que** les moyens d'ajustement en position portés par le module consistent en une vis de serrage (32) disposé transversalement à une paroi d'extrémité (24) du logement (8), ladite vis étant adaptée à coopérer avec un alésage taraudé (30) réalisé dans ladite face d'extrémité (24) pour pénétrer dans le logement selon ladite deuxième direction sous l'effet de sa rotation, afin de s'appuyer contre l'adaptateur (10 ; 110).

13. Module lumineux selon la revendication 12, **caractérisé en ce que** ladite vis de serrage (32) est une vis micrométrique.

14. Module lumineux selon la revendication 12 ou 13, **caractérisé en ce que** la paroi d'extrémité (24) du logement (8) porteuse de l'alésage taraudé (32) est formée dans l'épaisseur du moyen support (4 ; 104).

15. Module lumineux selon la revendication 12 ou 13, **caractérisé en ce que** la paroi d'extrémité (24) du logement (8) porteuse de l'alésage taraudé (32) est formée par une pièce rapportée et fixée sur le moyen support (4).

16. Module lumineux selon l'une des revendications 10 à 15, **caractérisé en ce que** les moyens de plaquage présentent la forme d'un fil (44) rigide articulé de manière à passer d'une position ouverte, dans laquelle le fil laisse libre accès au logement (8) formé dans le moyen support (4), à une position fermée, dans laquelle le fil est en travers dudit logement, ledit fil étant maintenu dans cette position fermée par encliquetage de crochets (54) formés par déformation du fil dans des moyens de réception femelles (42) prévus à cet effet sur le moyen support.

17. Module lumineux selon la revendication précédente, **caractérisé en ce que** le fil (44) est articulé sur le moyen support (4).

18. Module lumineux selon l'une des revendications 10 à 15, **caractérisé en ce que** les moyens de plaquage présentent la forme d'un ressort plat (88) fixé sur des pions (84) formés latéralement dans le moyen support du module, de manière à s'étendre transversalement au-dessus de l'adaptateur.

19. Ensemble d'éclairage et ou de signalisation d'un véhicule automobile, comportant un module lumineux (2) selon l'une des revendications 10 à 18 et un adaptateur (10),
- dans lequel l'adaptateur est placé et maintenu en position dans ledit logement (8) dudit moyen support (4 ; 104) du collecteur optique (6), comporte une source lumineuse (12, 13) rendue solidaire d'une face de l'adaptateur, comporte sur une face (66) opposée à la face de support (64) de ladite source lumineuse au moins une zone de réception (74 ; 90) de moyens de plaquage selon une première direction,
- dans lequel le module et l'adaptateur portent des moyens distincts d'une part pour le plaquage de l'adaptateur contre le moyen support (4) du module selon une première direction et d'autre part pour l'ajustement en position, selon une deuxième direction distincte de ladite première direction, de l'adaptateur dans un logement (8) formé dans ledit moyen support,
- et dans lequel l'ensemble d'éclairage et/ou de signalisation comporte des moyens de rappel élastique (78) aptes à être compressés selon ladite deuxième direction, ces moyens de rappel élastiques étant positionnés entre le support et l'adaptateur et portés par le support et/ou l'adaptateur.

20. Ensemble selon la revendication 19, **caractérisé en ce que** lesdits moyens d'ajustement en position comportent une vis de réglage (32) portée par le moyen support (4) et un moyen de rappel élastique (78) porté par l'adaptateur (10), l'action de la vis de réglage contre une face de l'adaptateur entraînant la compression des moyens de rappel élastique entre une face opposée de l'adaptateur contre une paroi du logement (8) formé dans le moyen support.

## Patentansprüche

1. Adapter (10; 110), der dazu geeignet ist, in einer Aufnahme (8) eines Tragmittels (4; 104) eines optischen Sammlers (6) eines Kraftfahrzeugs platziert und gehalten zu sein, der eine Lichtquelle (12, 13) umfasst, die mit einer Fläche des Adapters fest verbunden ist, der auf einer Fläche (66), die der Tragfläche (64) der Lichtquelle entgegengesetzt ist, mindestens eine Aufnahmezone (74; 90) von Andrückmitteln gemäß einer ersten Richtung umfasst, **dadurch gekennzeichnet, dass** der Adapter elastische Rückstellmittel (78) umfasst, die dazu angepasst sind, entlang einer zweiten Richtung, die von der ersten Richtung unterschiedlich ist, die insbesondere zu der ersten Richtung senkrecht ist, komprimiert zu werden.

2. Adapter nach Anspruch 1, **dadurch gekennzeichnet, dass** sich die elastischen Rückstellmittel (78) auf einer Kante des Adapters befinden, wobei die Kante insbesondere zu der Tragfläche senkrecht ist.

3. Adapter nach Anspruch 2, **dadurch gekennzeichnet, dass** die elastischen Rückstellmittel (78) die Form einer Blattfeder (80) aufweisen.

4. Adapter nach Anspruch 3, **dadurch gekennzeichnet, dass** die Blattfeder (80) in ihrer Mitte befestigt ist, um gegen die Kante des Adapters (10) angedrückt zu sein, und eine derart gekrümmte Form aufweist, dass sich in einer Ruheposition der Feder ihre Enden von der Kante entfernen.

5. Adapter nach Anspruch 3 oder 4, **dadurch gekennzeichnet, dass** die Blattfeder (80) außerdem eine Pratze (82) umfasst, die sich ausgehend von der Mitte dieser erstreckt und mit einem Stift (70), der fest mit der Fläche (66) des Adapters, die der Tragfläche (64) der Lichtquelle entgegengesetzt ist, in Eingriff kommt.

6. Adapter nach einem der Ansprüche 1 bis 5, **dadurch gekennzeichnet, dass** die Lichtquelle eine Licht emittierende Diode (12) ist, die von einer Leiterplatte (13) getragen wird, die fest mit der Tragfläche (64) des Adapters verbunden ist.

7. Adapter nach einem der Ansprüche 1 bis 6, **dadurch gekennzeichnet, dass** die Fläche (66), die der Tragfläche (64) der Lichtquelle entgegengesetzt ist, Rippen (68) umfasst, die sich in die erste Richtung vorragend erstrecken.

8. Adapter nach einem der Ansprüche 1 bis 7, **dadurch gekennzeichnet, dass** die Aufnahmezone (74) von Andrückmitteln aus Rillen besteht, die sich entlang der zweiten Richtung entlang der Enden des Adapters erstrecken.

9. Adapter nach einem der Ansprüche 1 bis 7, **dadurch gekennzeichnet, dass** die Aufnahmezone von Andrückmitteln aus einem Querkanal (90), der sich senkrecht zu der zweiten Richtung erstreckt, besteht.

10. Leuchtmodul (2), insbesondere zur Beleuchtung und/oder Signalisierung eines Kraftfahrzeugs, das mindestens einen Sammler (6) umfasst, der dazu geeignet ist, Lichtstrahlen zu reflektieren, damit diese entlang einer gegebenen optischen Achse abgeben, ein Tragmittel (4; 104), das den Sammler zum Teil bedeckt, und einen Adapter (10; 110), der eine Lichtquelle (12, 13) trägt, die dazu geeignet ist, die Lichtstrahlen abzugeben, wobei das Tragmittel eine Aufnahme (8) aufweist, die dazu geeignet ist, den Adapter aufzunehmen, **dadurch gekennzeichnet, dass** das Modul unterschiedliche Mittel für das Andrücken des Adapters entlang einer ersten Richtung einerseits und für die Positionseinstellung des Adapters entlang einer zweiten Richtung, die von der ersten Richtung unterschiedlich ist, insbesondere zu der ersten Richtung andererseits entgegengesetzt ist, umfasst.

11. Leuchtmodul nach Anspruch 10, **dadurch gekennzeichnet, dass** es elastische Rückstellmittel umfasst, die dazu geeignet sind, entlang der zweiten Richtung komprimiert zu sein.

12. Leuchtmodul nach Anspruch 10 oder 11, **dadurch gekennzeichnet, dass** die Positionseinstellmittel, die von dem Modul getragen werden, aus einer Spannschraube (32) bestehen, die quer zu einer Endwand (24) der Aufnahme (8) angeordnet ist, wobei die Schraube angepasst ist, um mit einer Gewindebohrung (30) zusammenzuwirken, die in der Endwand (24) hergestellt ist, um in die Aufnahme entlang der zweiten Richtung unter der Einwirkung ihrer Drehung einzudringen, um sich gegen den Adapter (10; 110) zu stützen.

13. Leuchtmodul nach Anspruch 12, **dadurch gekennzeichnet, dass** die Spannschraube (32) eine Feinstellschraube ist.

14. Leuchtmodul nach Anspruch 12 oder 13, **dadurch gekennzeichnet, dass** die Endwand (24) der Aufnahme (8), die die Gewindebohrung (32) trägt, in der Stärke des Tragmittels (4; 104) gebildet ist.

15. Leuchtmodul nach Anspruch 12 oder 13, **dadurch gekennzeichnet, dass** die Endwand (24) der Aufnahme (8), die die Gewindebohrung (32) trägt, in einem Teil gebildet ist, der auf dem Tragmittel (4) angefügt und befestigt ist.

16. Leuchtmodul nach einem der Ansprüche 10 bis 15, **dadurch gekennzeichnet, dass** die Andrückmittel die Form eines starren Drahts (44) aufweisen, der derart angelenkt ist, dass er von einer offenen Position, in der der Draht freien Zugang zu der Aufnahme (8), die in dem Tragmittel (4) gebildet ist, lässt, zu einer geschlossenen Position, in der der Draht quer über die Aufnahme liegt, übergeht, wobei der Draht durch Einrasten von Haken (54), die durch Verformung des Drahts gebildet sind, in Buchsenaufnahmemittel (42), die dazu auf dem Tragmittel vorgesehen sind, in dieser geschlossenen Position gehalten wird.

17. Leuchtmodul nach dem vorstehenden Anspruch, **dadurch gekennzeichnet, dass** der Draht (44) auf dem Tragmittel (4) angelenkt ist.

18. Leuchtmodul nach einem der Ansprüche 10 bis 15, **dadurch gekennzeichnet, dass** die Andrückmittel die Form einer Federscheibe (88) aufweisen, die durch Stifte (84), die seitlich in dem Tragmittel des Moduls gebildet sind, derart befestigt ist, dass sie sich quer oberhalb des Adapters erstreckt.

19. Beleuchtungs- und oder Signalisierungseinheit eines Kraftfahrzeugs, die ein Leuchtmodul (2) nach einem der Ansprüche 10 bis 18 und einen Adapter (10) umfasst,
- wobei der Adapter in der Aufnahme (8) des Tragmittels (4; 104) des optischen Sammlers (6) platziert und in Position gehalten ist, eine Lichtquelle (12, 13) umfasst, die mit einer Fläche des Adapters fest verbunden ist, eine Fläche (66) aufweist, die der Tragfläche (64) der Lichtquelle mindestens einer Aufnahmezone (74; 90) von Andrückmitteln entlang einer ersten Richtung entgegengesetzt ist,
- wobei das Modul und der Adapter unterschiedliche Mittel einerseits für das Andrücken des Adapters gegen das Tragmittel (4) des Moduls entlang einer ersten Richtung tragen, und andererseits für die Positionseinstellung entlang einer zweiten Richtung, die von der ersten Richtung unterschiedlich ist, des Adapters in einer Aufnahme (8), die in dem Tragmittel gebildet ist,
- und wobei die Beleuchtungs- und/oder Signalisierungseinheit elastische Rückstellmittel (78) umfasst, die dazu geeignet sind, entlang der zweiten Richtung komprimiert zu werden, wobei diese elastischen Rückstellmittel zwischen dem Träger und dem Adapter positioniert sind und von dem Träger und/oder dem Adapter getragen werden.

20. Einheit nach Anspruch 19, **dadurch gekennzeichnet, dass** die Positionseinstellungsmittel eine Einstellschraube (32) umfassen, die von dem Tragmittel (4) getragen wird, und ein elastisches Rückstellmittel (78), das von dem Adapter (10) getragen wird, wobei die Wirkung der Einstellschraube gegen eine Fläche des Adapters die Kompression der elastischen Rückstellmittel zwischen einer entgegengesetzten Fläche des Adapters gegen eine Wand der Aufnahme (8), die in dem Tragmittel gebildet ist, nach sich zieht.

## Claims

1. Adapter (10; 110) that can be placed and retained in position in a housing (8) of support means (4; 104) of an optical collector (6) of a motor vehicle, including a light source (12, 13) fastened to one face of the adapter, including on a face (66) opposite the support face (64) of said light source at least one receiving area (74; 90) of pressing means acting in a first direction, **characterized in that** the adapter includes elastic return means (78) that can be compressed in a second direction other than said first direction, notably perpendicular to said first direction.

2. Adapter according to Claim 1, **characterized in that** the elastic return means (78) are on an edge surface of the adapter, the edge surface being notably perpendicular to said support face.

3. Adapter according to Claim 2, **characterized in that** the elastic return means (78) take the form of a leaf spring (80).

4. Adapter according to Claim 3, **characterized in that** the leaf spring (80) is fixed at its center to be pressed against the edge surface of the adapter (10), and having a curved shape so that in a rest position of said spring its ends are away from said edge surface.

5. Adapter according to Claim 3 or 4, **characterized in that** the leaf spring (80) further includes a lug (82) that extends from the center thereof and that engages with a pin (70) fastened to the face (66) of the adapter opposite the support face (64) of said light source.

6. Adapter according to any one of Claims 1 to 5, **characterized in that** said light source is a light-emitting diode (12) carried by a printed circuit board (13) fastened to said support face (64) of the adapter.

7. Adapter according to any one of Claims 1 to 6, **characterized in that** the face (66) opposite the support face (64) of said light source includes ribs (68) that project in the first direction.

8. Adapter according to any one of Claims 1 to 7, **characterized in that** the area (74) receiving pressing means consists in grooves that extend in the second direction along edges of the adapter.

9. Adapter according to any one of Claims 1 to 7, **characterized in that** the area receiving pressing means consists in a transverse channel (90) that extends perpendicularly to the second direction.

10. Lighting module (2), notably for lighting and/or signaling in a motor vehicle, including at least one collector (6) that can reflect light rays so that the latter are emitted along a given optical axis, support means (4; 104) partly covering said collector, and an adapter (10; 110) carrying a light source (12, 13) adapted to emit said light rays, said support means including a housing (8) that can receive said adapter, **characterized in that** said module includes separate means for pressing the adapter in a first direction and for the adjustment in position of the adapter in a second direction other than said first direction, notably perpendicular to said first direction.

11. Lighting module according to Claim 10, **characterized in that** it includes elastic return means that can be compressed in said second direction.

12. Lighting module according to Claim 10 or 11, **characterized in that** the position adjustment means carried by the module consist in a clamping screw (32) disposed transversely to an end wall (24) of the housing (8), said screw being adapted to cooperate with a threaded bore (30) in said end face (24) to penetrate into the housing in said second direction as a result of its rotation, in order to press against the adapter (10; 110).

13. Lighting module according to Claim 12, **characterized in that** said clamping screw (32) is a micrometer screw.

14. Lighting module according to Claim 12 or 13, **characterized in that** the end wall (24) of the housing (8) carrying the threaded bore (32) is formed in the thickness of the support means (4; 104).

15. Lighting module according to Claim 12 or 13, **characterized in that** the end wall (24) of the housing (8) carrying the threaded bore (32) is formed by a part mounted on and fixed to the support means (4).

16. Lighting module according to any one of Claims 10 to 15, **characterized in that** the pressing means take the form of a rigid wire (44) articulated so as to go from an open position, in which the wire allows free access to the housing (8) formed in the support means (4), to a closed position, in which the wire is across said housing, said wire being held in this closed position by clipping hooks (54) formed by deformation of the wire into female receiving means (42) provided for this purpose on the support means.

17. Lighting module according to the preceding claim, **characterized in that** the wire (44) is articulated to the support means (4).

18. Lighting module according to any one of Claims 10 to 15, **characterized in that** the pressing means take the form of a flat spring (88) fixed onto pins (84) formed laterally in the support means of the module, so as to extend transversely above the adapter.

19. Motor vehicle lighting and/or signaling assembly including a lighting module (2) according to any one of Claims 10 to 18 and an adapter (10), wherein:
- the adapter is placed and retained in position in said housing (8) of said support means (4; 104) of the optical collector (6), includes a light source (12, 13) fastened to one face of the adapter, and includes on a face (66) opposite the support face (64) of said light source at least one area (74; 90) receiving pressing means acting in a first direction,
- the module and the adapter carry separate means for pressing the adapter against the support means (4) of the module in a first direction and for the adjustment in position, in a second direction other than said first direction, of the adapter in a housing (8) formed in said support means, and
- the lighting and/or signaling assembly includes elastic return means (78) adapted to be compressed in said second direction, these elastic return means being positioned between the support and the adapter and carried by the support and/or the adapter.

20. Assembly according to Claim 19, **characterized in that** said position adjustment means include an adjustment screw (32) carried by the support means (4) and elastic return means (78) carried by the adapter (10), the action of the adjustment screw against a face of the adapter leading to the compression of the elastic return means between an opposite face of the adapter against a wall of the housing (8) formed in the support means.
